# EUROPÄISCHE PATENTSCHRIFT

(11) **EP 0 809 371 B1**
(45) Veröffentlichungstag und Bekanntmachung des Hinweises auf die Patenterteilung: **05.02.2003**
(21) Anmeldenummer: 97100329.8
(22) Anmeldetag: 10.01.1997
(51) Int. Cl.: H04B 10/28

(54) **Datensende- und -empfangsschaltung**
Data emitting and receiving circuit
Circuit d'émission et de réception de données

(30) Priorität: 23.05.1996 DE 19620866
(43) Veröffentlichungstag der Anmeldung: 26.11.1997
(73) Patentinhaber: Ziegler, Horst Prof. Dr., D-33100 Paderborn (DE)
(72) Erfinder: Ziegler, Horst, Prof.Dr., 33100 Paderborn (DE); Ziegler, Martin Andreas, 33100 Paderborn (DE); Ziegler, Ulrike Claudia, 71063 Sindelfingen (DE); Ziegler, Tobias Irmo, 33100 Paderborn (DE)
(74) Vertreter: Tiesmeyer, Johannes, Dr.

(56) Entgegenhaltungen:
- EP-A- 0 064 025
- EP-A- 0 163 138
- EP-A- 0 651 509
- DE-A- 3 035 944
- PATENT ABSTRACTS OF JAPAN vol. 017, no. 134 (E-1334), 19.März 1993 & JP 04 304798 A (AKAI ELECTRIC CO LTD), 28.Oktober 1992,
- PATENT ABSTRACTS OF JAPAN vol. 011, no. 390 (E-567), 19.Dezember 1987 & JP 62 154791 A (HITACHI VLSI ENG CORP;OTHERS: 01), 9.Juli 1987,
- PATENT ABSTRACTS OF JAPAN vol. 012, no. 232 (E-628), 30.Juni 1988 & JP 63 023431 A (NEC CORP), 30.Januar 1988,

## Beschreibung

Die Erfindung betrifft eine Datensende- und -empfangsschaltung zum Senden und Empfangen optischer Datensignale, bei der wenigstens eine Licht emittierende Diode (Leuchtdiode) als optoelektronisches Sendeelement zur Umwandlung eines elektrischen Datensignals in ein optisches Datensignal und zum Senden des optischen Datensignals an einer das elektrische Datensignal in einem Datensendemodus der Datensende- und -empfangsschaltung bereitstellenden Steuerschaltung angeschlossen ist.

Derartige Datensende- und -empfangsschaltungen werden beispielsweise in Optokopplerschaltungen für bidirektionale optische Datenübertragung verwendet, wobei in konventionellen optischen Datenübertragungsschnittstellen neben der als optischer Sender wirksamen Leuchtdiode stets eine Photodiode oder ein Phototransistor als optisches Empfangselement vorgesehen ist. In einer Optokopplerschaltung herkömmlichen Typs sind für den Aufbau einer bidirektionalen optischen Kommunikationsstrecke zwei Datensende- und -empfangsschaltungen erforderlich, deren jede eine Leuchtdiode zum Senden und einen Phototransistor bzw. eine Phötodiode zum Empfangen aufweist.

Datensende- und -empfangsschaltungen der vorstehend genannten Art werden beispielsweise bei elektronischen Heizkostenverteilern verwendet, die ortsfest an einem betreffenden Heizkörper montiert sind, um Verbrauchswerte zu messen. Die Verbrauchsmeßwerte können von einem transportablen Auslesegerät ausgelesen werden, wobei die Auslesung per optischer Datenübertragung vom Heizkostenverteiler zum Auslesegerät erfolgt. Andererseits können auch Daten, wie etwa Ablesezeiten und dgl., vom Auslesegerät zum Heizkostenverteiler übertragen werden.

Aus der DE 30 35 944 A1 ist eine optoelektronische Halbleiteranordnung, nämlich eine Anzeigeanordnung mit Leuchtdioden als visuelle Anzeigeelemente bekannt. Die Leuchtstärke der Leuchtdioden wird geregelt, um eine Kontrastverbesserung zu erzielen bzw. um die Leuchtstärke der Umgebungshelligkeit jeweils anzupassen. Hierzu wird in der DE 30 35 944 A1 vorgeschlagen, die Leuchtdioden in Zeitintervallen, in denen sie nicht zur Emission von Licht eingeschaltet sind, als Photoelemente und somit als Sensoren in dem Regelkreis für die Leuchtstärkeregelung zu betreiben. Die betreffende Leuchtdiode wird somit als Analogsensor zur Messung der Umgebungshelligkeit genutzt.

Zum Stand der Technik wird ferner auf die EP 0 651 509 A oder die DE 43 36 669 C1 verwiesen, welche ein Eingabefeld mit "logarithmischen optischen Tasten" betrifft. Bei dem Eingabefeld sind einzelnen Betätigungsflächen optoelektronische Betätigungssensoren zugeordnet, welche auf Helligkeitsänderungen ansprechen, die beim Aufsetzen eines Fingers auf eine Betätigungsfläche eintreten. Als optische Betätigungssensoren werden Photodioden oder Leuchtdioden verwendet, die im Leerlauf als Photoelemente betrieben werden. Die Dioden erzeugen eine Leerlaufspannung, die in Abhängigkeit von dem auf sie auffallenden Lichtstrom in etwa logarithmisch zunimmt. Derartige Betätigungssensoren liefern daher ein Ausgangssignal, dessen Amplitude sich mit Änderungen in der auffallenden Lichtintensität nur verhältnismäßig wenig ändert. Damit führen auch starke Änderungen in der Umgebungshelligkeit nicht zu großen Änderungen im Ausgangssignal. Eine mit den Dioden verbundene Auswerteeinheit besorgt die entsprechende Unterscheidung zwischen raschen Änderungen und langsamen Änderungen der Lichtintensität, um eine Tastenbetätigung von Schwankungen der Umgebungshelligkeit unterscheiden zu können.

Der Erfindung liegt die Aufgabe zugrunde, eine Datensendeund -empfangsschaltung der gattungsgemäßen Art zu vereinfachen.

Zur Lösung dieser Aufgabe wird erfindungsgemäß vorgeschlagen, daß die Leuchtdiode in einem Datenempfangsmodus der Datensende- und -empfangsschaltung von der Steuerschaltung derart angesteuert ist, daß sie als optoelektronisches Datenempfangselement zur Umwandlung eines von ihr empfangenen optischen Datensignals in ein von der Steuerschaltung registriertes elektrisches Datensignal wirksam ist, wobei die Steuerschaltung die Leuchtdiode in Sperrichtung vorspannt und ein vom Sperrstrom der Leuchtdiode und somit von der Intensität des in die Leuchtdiode einfallenden Lichtes abhängiges elektrisches Signal in einer binäre Zustände des von der Leuchtdiode empfangenen optischen Datensignals unterscheidenden Weise detektiert.

Der Erfindung liegt somit die Idee zugrunde, das Sendeelement und das Empfangselement einer gattungsgemäßen Datensende- und -empfangsschaltung in einem optoelektronischen Bauelement zu vereinigen, das nach Maßgabe der jeweiligen Betriebsart (Senden oder Empfangen) von der Steuerschaltung wechselweise als Sendeelement und als Empfangselement angesteuert wird, wobei die Leuchtdiode im Datenempfangsmodus im krassen Gegensatz zu ihrer eigentlichen Bestimmung als Photodiode betrieben wird. Das optoelektronische Bauelement kann insbesondere eine herkömmliche Leuchtdiode, wie etwa eine IR-Leuchtdiode oder eine im sichtbaren Bereich emittierende Leuchtdiode, sein. Es ist bisher nicht erkannt und in die Praxis umgesetzt worden, daß Leuchtdioden, deren elektrooptischer Wirkungsmechanismus aufgrund der Wahl des Basishalbleitermaterials und der speziellen Dotierung auf optimale Lichtemission ausgerichtet ist, eine Sperrstrom-Photoempfindlichkeit aufweisen, die dazu ausreicht, die bei der optischen Datenübertragung üblichen ein/aus-Intensitätskontrastunterschiede zuverlässig zu unterscheiden.

Bei der Datensende- und -empfangsschaltung nach der Erfindung fällt somit der bei gattungsgemäßen Schaltungen nach dem Stand der Technik übliche Phototransistor für den Datenempfang weg, was die Schaltung insgesamt vereinfacht und kostengünstiger macht.

Sofern bei der Datensende- und -empfangsschaltung nach der Erfindung Datenübertragung über lediglich einen seriellen Datenübertragungskanal erfolgen soll, so ist bei Verwendung einer einzelnen Leuchtdiode als Sende- und Empfangselement zwar nur Halbduplex-Betrieb möglich. Dies stellt jedoch bei vielen Anwendungen und Protokollen keine Einschränkung dar.

Exemplarstreuungsmessungen haben überraschenderweise gezeigt, daß die Lichtempfangsempfindlichkeit von Leuchtdioden eine systematische und reproduzierbare Eigenschaft ist, so daß handelsübliche Leuchtdioden nicht erst auf ihre Verwendbarkeit in einer Datensende- und -empfangsschaltung nach der Erfindung geprüft werden müssen.

Die Verwendung einer Diode sowohl als Empfangs- als auch als Sendeelement bietet aufgrund des großen Raumwinkels, unter dem Licht abgestrahlt und empfangen werden kann, ferner den Vorteil, daß es bei einer optischen Kommunikationsstrecke aus zwei optisch miteinander kommunizierenden Datensende- und -empfangsschaltungen nach der Erfindung weniger auf exakte Ausrichtung der einander gegenüber liegenden Dioden ankommt, als es bei herkömmlichen Systemen mit jeweils gesonderten optoelektronischen Bauelementen für das Senden und für das Empfangen der Fall ist.

Bei einer bevorzugten Ausführungsform der Erfindung ist die Diode kathodenseitig über einen ersten Widerstand mit einem H-Potential führenden ersten Ausgangsanschluß der Steuerschaltung - und anodenseitig mit einem zweiten Ausgangsanschluß der Steuerschaltung verbunden, der im Datensendemodus H-Potential und im Datenempfangsmodus L-Potential führt, wobei die Steuerschaltung einen mit der Kathode der Diode verbundenen Datenausgangsanschluß zur Abgabe eines elektrischen Datensignals im Datensendemodus aufweist. Die Steuerschaltung steuert über den an der Anode der Diode anliegenden Pegel des zweiten Ausgangsanschlusses die Übertragungsrichtung der optischen Datenübertragung. Führt der zweite Ausgangsanschluß L-Pegel, so ist die Diode in Sperrichtung gepolt, und die Datensende- und -empfangsschaltung ist in Empfangsbereitschaft. Im Datensendemodus wird die Diode anodenseitig mit H-Potential vom zweiten Ausgangsanschluß aus angesteuert, wobei dann abhängig von dem über den Datenausgangsanschluß abgegebenen Datensignal das an der Kathode der Diode anliegende Potential moduliert wird, was sich in einer entsprechenden Helligkeitsmodulation der Diode äußert, so daß die Diode ein entsprechendes optisches Datensignal abstrahlt.

Besteht das über den Datenausgangsanschluß der Steuerschaltung abgegebene elektrische Datensignal aus einer H-/L-Bitfolge, so gibt die Diode ein Lichtsignal ab, wenn der momentane Zustand des elektrischen Datensignals L ist, und erlischt die Diode, wenn der momentane Zustand des Datensignals H ist. Vorzugsweise ist zwischen der Kathode der Diode und dem Datenausgangsanschluß der Steuerschaltung ein Widerstand geschaltet.

Für die elektrische Registrierung empfangener optischer Daten ist ein hochohmiger Eingangsanschluß der Steuerschaltung mit der Kathode der Diode verbunden.

In einer besonders bevorzugten Ausführungsform hat die Steuerschaltung einen bidirektionalen Datenübertragungsport, über den sie im Datensendemodus das elektrische Datenausgangssignal bereitstellt und über den sie im Datenempfangsmodus die vom Sperrstrom der Leuchtdiode abhängige Spannung als Eingangssignal detektiert. Im Datenempfangsmodus ist der über einen Widerstand mit der Kathode der Leuchtdiode verbundene Anschluß des bidirektionalen Datenübertragungsports in einem sehr hochohmigen Zustand.

Die Steuerschaltung umfaßt zur Steuerung des Datensende- und -empfangsbetriebs vorzugsweise einen Mikroprozessor.

Zweckmäßigerweise weist die Steuerschaltung eine serielle Schnittstelle zur bidirektionalen asynchronen Datenübertragung über die Diode im Halbduplex-Betrieb auf, wobei die Datenübertragung nach einem Standardprotokoll erfolgen kann.

Gemäß einer Weiterbildung der Erfindung ist vorgesehen, daß die Diode in einem Gehäuse mit einer zur Diode hin lichtdurchlässigen Gehäuseöffnung angeordnet ist, die einer Tastenfläche für manuelle Dateneingabe zugeordnet ist, wobei die Datensende- und -empfangsschaltung unter Kontrolle der Steuerschaltung ferner in einem Tasteneingabemodus betreibbar ist, in dem die Diode im Leerlauf als Photoelement wirksam ist und die Steuerschaltung die von der Intensität des von der Diode empfangenen Lichtes abhängige Leerlaufspannung der Diode erfaßt, um eine den Lichtdurchlaß zur Diode verändernde plötzliche Abschattung der Gehäuseöffnung als manuellen Dateneingabevorgang zu registrieren.

Die Diode dient somit in dem von der Steuerschaltung im Multiplexbetrieb eingeschalteten Tasteneingabemodus als logarithmische optische Taste, wie sie vom Grundprinzip her aus der DE 43 36 669 C1 bekannt ist.

Gemäß einer bevorzugten Weiterbildung wird die Diode im Tasteneingabemodus von der Steuerschaltung aus derart angesteuert, daß sie anodenseitig mit H-Potential - und kathodenseitig mit einem hochohmigen Eingang eines Analog/Digital-Wandlers der Steuerschaltung verbunden ist, wobei die Steuerschaltung einen Mikroprozessor zur Auswertung der von dem Analog/Digital-Wandler bereitgestellten Informationen aufweist. Über den Analog/Digital-Wandler erfaßt der Mikroprozessor die auf H-Potential (Vcc) bezogene Leerlaufspannung der Diode. Stellt der Mikroprozessor bei der Differenzbildung zweier aufeinanderfolgend gemessener Spannungswerte fest, daß die Leerlaufspannung der Diode mit einer Mindeständerungsgeschwindigkeit abrupt abgesunken ist, so wird dies vom Mikroprozessor als Bedienung der logarithmischen optischen Taste interpretiert.

Gemäß einer weiteren Ausführungsform der Erfindung ist die Datensende- und -empfangsschaltung als optische Kommunikationsschnittstelle eines Meßgerätes ausgebildet, welches zum optischen Datenaustausch mit einem zweiten Gerät eingerichtet ist, wobei das zweite Gerät als optische Kommunikationsschnittstelle ebenfalls eine Datensende- und -empfangsschaltung nach der Erfindung aufweisen kann.

Das Meßgerät kann ein an einer Verbrauchsstelle zu installierender elektronischer Verbrauchszähler, beispielsweise ein Heizkostenverteiler, Wasserzähler, Wärmemengenzähler, Gaszähler, Stromzähler oder dgl., sein, wobei es sich bei dem zweiten Gerät um ein transportables Auslesegerät handeln kann, das mit dem Verbrauchszähler Daten austauschen kann.

Sofern die Datensende- und -empfangsschaltung bei dem Verbrauchszähler auch für den Tasteneingabemodus ausgelegt und die Diode im Tasteneingabemodus als Tastenbetätigungssensor wirksam ist, so kann vorgesehen sein, daß durch eine Bedienung der entsprechenden logarithmischen optischen Taste zwischen verschiedenen Anzeigebetriebsarten eines Displays des Verbrauchszählers umgeschaltet werden kann.

Gemäß einer Variante der Ausführungsform mit logarithmischer optischer Taste wird vorgeschlagen, daß mit der Diode ein Kondensator verbunden ist, der in einem Ladebetriebszustand der Steuerschaltung im Tasteneingabemodus einen der Leerlaufspannung der Diode entsprechenden Ladezustand annimmt und der in einem nachfolgenden Entladebetriebszustand der Steuerschaltung im Tasteneingabemodus über einen Entladewiderstand entladbar ist, wobei die Steuerschaltung einen mit einem Verbindungspunkt zwischen der Diode und dem Kondensator verbundenen, hochohmigen Eingangsport zur Überwachung der Kondensatorentladung aufweist und dazu eingerichtet ist, als Maß für die Leerlauf spannung der Diode die Zeit zu messen, die vergeht, bis die am Eingangsport anliegende Spannung während des Kondensatorentladevorgangs eine vorbestimmte Schaltschwellspannung des Eingangsports erreicht.

Gemäß einer bevorzugten Weiterbildung der vorstehend genannten Variante ist die Diode anodenseitig mit einem ersten Ausgangsport der Steuerschaltung - und kathodenseitig über den Kondensator mit einem H-Potential führenden Anschluß verbunden, wobei die Diode kathodenseitig ferner über den Entladewiderstand mit einem zweiten Ausgangsport - und über einen weiteren Widerstand mit dem Eingangsport verbunden ist, wobei ferner der erste Ausgangsport im Ladebetriebszustand definiertes H-Potential führt und im Entladebetriebszustand in einen hochohmigen Tri-state-Zustand geschaltet ist, wobei ferner der zweite Ausgangsport im Ladebetriebszustand in einen hochohmigen Tri-state-Zustand geschaltet ist und im Entladebetriebszustand definiertes L-Potential führt, und wobei die Steuerschaltung im Entladebetriebszustand als Maß für die Leerlaufspannung der Diode die Zeit mißt, die vergeht, bis die Spannung an dem hochohmigen Eingangsport auf die Schaltschwellspannung des Eingangsports abgesunken ist, deren Unterschreiten die Mikroprozessorschaltung als Übergang von H-Pegel nach L-Pegel interpretiert.

Die Erfindung wird nachstehend anhand von Ausführungsbeispielen unter Bezugnahme auf die Figuren näher erläutert.
- Fig. 1a: zeigt ein teils in Blockdarstellung gezeichnetes Schaltbild eines ersten Ausführungsbeispiels einer Datensende- und -empfangsschaltung nach der Erfindung.
- Fig. 1b: ist eine Zustandstabelle, aus der ersichtlich ist, wie bestimmte Anschlüsse der Steuerschaltung von der Steuerschaltung aus in verschiedenen Betriebszuständen angesteuert werden.
- Fig. 2a: zeigt ein teils in Blockdarstellung gezeichnetes Schaltbild eines zweiten Ausführungsbeispiels einer Datensende- und -empfangsschaltung nach der Erfindung mit einer integrierten optischen Taste.
- Fig. 2b: zeigt für die Schaltung nach Fig. 2a eine Zustandstabelle, in der dargestellt ist, wie verschiedene Anschlüsse der Steuerschaltung von der Steuerschaltung aus in verschiedenen Betriebszuständen angesteuert werden.
- Fig. 3a: zeigt ein teils in Blockdarstellung gezeichnetes Schaltbild eines dritten Ausführungsbeispiels der Erfindung mit einer integrierten optischen Taste.
- Fig. 3b: zeigt für die Schaltung nach Fig. 3a ein Zustandsdiagramm, aus dem ersichtlich ist, wie bestimmte Anschlüsse der Steuerschaltung von der Steuerschaltung aus in verschiedenen Betriebszuständen angesteuert werden.
- Fig. 3c: ist ein Spannungs-Zeit-Diagramm zur Erläuterung der Betriebsweise der Schaltung nach Fig. 3a in einem Tasteneingabebetriebsmodus.
- Fig. 4: zeigt eine Steuerschaltung zur Registrierung der Betätigung optischer Tasten.
- Fig. 5: illustriert ein konkretes Anwendungsbeispiel für eine Datensende- und -empfangsschaltung nach der Erfindung.

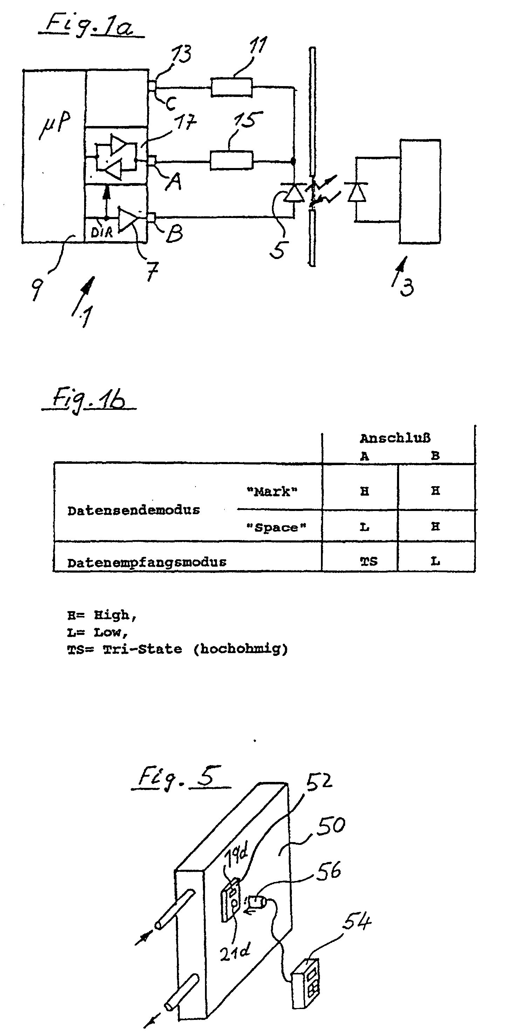

In Fig. 1a ist ein teils in Blockdarstellung gezeichnetes Schaltbild eines ersten Ausführungsbeispiels einer Datensendeund -empfangsschaltung nach der Erfindung dargestellt.

Die Datensende- und -empfangsschaltung 1 enthält für den optischen Datenaustausch mit einem in Fig. 1a bei 3 angedeuteten Gerät eine herkömmliche Infrarot-Leuchtdiode 5, die in der Datensende- und -empfangsschaltung 1 sowohl zum Senden - als auch zum Empfangen optischer Daten im Halbduplex-Betrieb genutzt wird.

Die Leuchtdiode 5 ist mit ihrer Anode an einem Ausgangsport 7 einer programmierbaren Steuerschaltung 9 angeschlossen, bei der es sich vorzugsweise um eine Mikroprozessorschaltung handelt.

Die Kathode der Leuchtdiode 5 ist über einen ersten Widerstand 11 von beispielsweise 1,5 MΩ mit einem H-Potential führenden Vcc-Anschluß 13 der Steuerschaltung 9 - und über einen zweiten Widerstand 15 von beispielsweise 680 Ω mit einem bidirektionalen Datenübertragungsport 17 der Steuerschaltung 9 verbunden.

Die Datensende- und -empfangsschaltung 1 ist zur asynchronen, bitseriellen Datenübertragung im Halbduplexbetrieb eingerichtet, wobei die Steuerschaltung 9 den Datensende- und -empfangsbetrieb gemäß einem Standardprotokoll für serielle Datenübertragung steuert.

In Fig. 1b ist eine Tabelle gezeigt, in der die elektrischen Zustände bzw. Pegel der Anschlüsse A und B der Ports 17 bzw. 7 in Abhängigkeit vom momentanen Betriebszustand der Datensendeund -empfangsschaltung 1 nach Fig. 1a dargestellt sind.

Im Datensendemodus steuert die Steuerschaltung 9 den Ausgangsport 7 derart an, daß der Anschluß B H-Pegel führt. Über den Anschluß A des Datenübertragungsports 17 gibt die Steuerschaltung 9 dann entsprechend dem zu sendenden Signal eine Bitfolge aus, wobei der Pegel am Anschluß A entsprechend der Bitfolge zwischen H (= "Mark") und L (= "Space") wechselt. Dies führt zu einer entsprechenden Modulation der Helligkeit der Leuchtdiode 5, wobei die Leuchtdiode 5 in Flußrichtung betrieben wird und entsprechend aufleuchtet, wenn am Ausgang A L-Pegel vorliegt, wohingegen die Leuchtdiode 5 erlischt, wenn am Ausgang A H-Pegel vorliegt. Die Leuchtdiode 5 sendet somit ein optisches Datensignal aus, das der über den Ausgang A der Steuerschaltung 9 abgegebenen Bitfolge entspricht.

Das von der Leuchtdiode 5 abgegebene Signal wird im Beispiel der Figur 1a von dem zweiten Gerät 3 empfangen, welches als Kommunikationspartner der Datensende- und -empfangsschaltung 1 nach einem entsprechenden Datenübertragungsprotokoll arbeitet.

Zum Einschalten des Datenempfangsmodus steuert die Steuerschaltung 9 die Anode der Leuchtdiode 5 über den Anschluß B des Ports 7 mit L-Pegel an, um die kathodenseitig über den ersten Widerstand 11 mit H-Potential verbundene Leuchtdiode 5 in Sperrichtung vorzuspannen, und der mit einem Tri-State-Buffer ausgestattete bidirektionale Datenübertragungsport 17 wird von der Steuerschaltung 9 auf Datenempfang umgeschaltet, wobei der Anschluß A nunmehr einen sehr hochohmigen Eingangsanschluß bildet.

Der Vorwiderstand 11 hat einen vergleichsweise großen Widerstandswert von beispielsweise 1,5 MΩ. Die im Datenempfangsmodus von der Steuerschaltung 9 als Photodiode betriebene Leuchtdiode 5 weist in Sperrichtung einen (sehr kleinen) Sperrstrom auf, der stark von der Intensität des zur Leuchtdiode einfallenden Lichtes abhängt. Bei Empfang eines optischen Datensignals in Form einer Hell/Dunkel-Bitfolge wird der Sperrstrom der Diode 5 entsprechend moduliert, so daß an dem hochohmigen Anschluß A des bidirektionalen Datenübertragungsports 17, der über den zweiten Widerstand 15 mit der Kathode der Diode 5 verbunden ist, ein entsprechendes elektrisches Datensignal erscheint, welches von der Steuerschaltung 9 als Empfangsdatensignal registriert wird.

Das als optischer Kommunikationspartner der Datensende- und - empfangsschaltung 1 nach der Erfindung dargestellte Gerät 3 kann ebenfalls mit einer Datensende- und -empfangsschaltung ausgestattet sein, wie sie in Fig. 1a mit 1 gekennzeichnet ist. Alternativ könnte ein betreffendes Gerät 3 jedoch in konventioneller Weise mit gesonderten optischen Elementen für die Sendung und für den Empfang optischer Datensignale versehen sein.

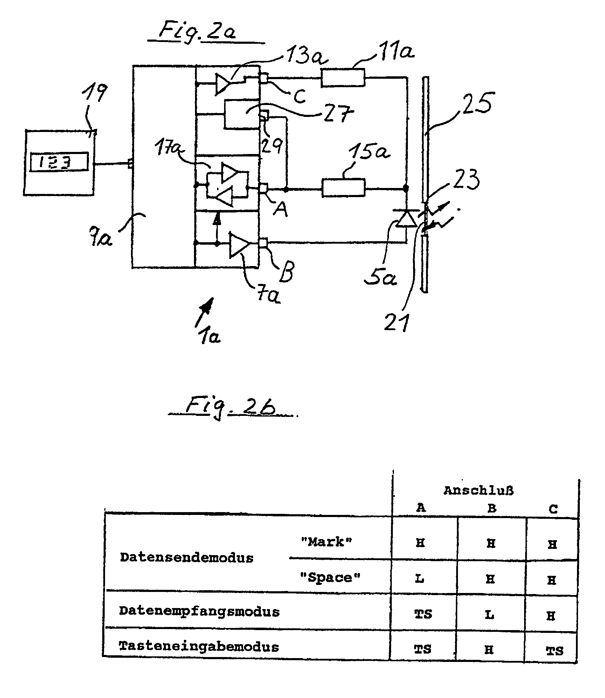

In Fig. 2a ist ein teils in Blockdarstellung gezeichnetes Schaltbild eines zweiten Ausführungsbeispiels der Erfindung dargestellt.

Elemente der Schaltung nach Fig. 2a, die Elementen nach Fig. 1a entsprechen, sind jeweils mit übereinstimmenden Bezugsziffern und dem nachgestellten Buchstaben a gekennzeichnet, so daß insoweit auf die Beschreibung des Ausführungsbeispiels nach Fig. 1a verwiesen werden kann und sich die folgenden Erläuterungen zu dem Ausführungsbeispiel nach Fig. 2a im wesentlichen auf Unterschiede zum ersten Ausführungsbeispiel beschränken können.

Das Ausführungsbeispiel nach Fig. 2a stellt gegenüber dem ersten Ausführungsbeispiel eine Erweiterung dahingehend dar, daß die Leuchtdiode 5a nicht nur zur bidirektionalen gelegentlichen Datenkommunikation, sondern in einem Multiplex-Betrieb auch als Betätigungssensor einer sog. logarithmischen optischen Taste verwendet wird, wie sie an sich aus dem deutschen Patent DE 43 36 669 C1 bekannt ist. Eine solche Taste kann beispielsweise dazu dienen, eine bestimmte Anzeigebetriebsart einer an der Steuerschaltung 9a angeschlossenen Datenanzeigeeinrichtung 19 durch manuelle Bedienung der Taste einzuschalten.

Manuelle Bedienung der Taste bedeutet bei dem Ausführungsbeispiel nach der Fig. 2a, daß eine Bedienungsperson das bei 21 angedeutete, zur Diode 5a hin lichtdurchlässige Fenster in der Bedienungsfläche 23 mit dem Finger abschattet. Die Bedienungsfläche 23 befindet sich an der bei 25 angedeuteten Gehäusewand.

Zusätzlich zu den Betriebsarten Daten senden und Daten empfangen, wie sie unter Bezugnahme auf Fig. 1a bereits beschrieben worden sind, weist die Schaltung nach Fig. 2a einen Tasteneingabemodus auf, in dem die Leuchtdiode 5a im Leerlauf betrieben und ihre Leerlaufspannung detektiert wird, die näherungsweise proportional zum Logarithmus der Intensität des in die Leuchtdiode einfallenden Lichtes ist.

Abweichend von dem Ausführungsbeispiel nach Fig. 1a ist die Leuchtdiode 5a über den Vorwiderstand 11a kathodenseitig an einem Ausgangsport 13a angeschlossen, welcher von der Steuerschaltung 9a in einen hochohmigen Tri-state-Zustand schaltbar ist, so daß der Ausgang 13a in diesem Zustand quasi elektrisch abgeschaltet ist.

Fig. 2b zeigt eine Tabelle, in der die elektrischen Zustände der Anschlüsse A, B und C der Ports 17a, 7a bzw. 13a in Abhängigkeit vom jeweiligen Betriebszustand der Schaltung 1a eingetragen sind.

Hinsichtlich der Betriebszustände: Datensendemodus und Datenempfangsmodus liegen die gleichen Verhältnisse vor wie bei dem Ausführungsbeispiel nach Fig. 1a (vgl. Tabelle Fig. 1b). Im Tasteneingabemodus weisen die Anschlüsse A und C den hochohmigen Tri-state-Zustand TS und der Anschluß B H-Pegel auf, was bedeutet, daß die Leuchtdiode 5a im Leerlaufbetrieb ist.

Zur Erfassung der Leerlaufspannung weist die vorzugsweise als Mikroprozessorschaltung ausgebildete Steuerschaltung 9a einen Analog/Digital-Wandler 27 mit einem sehr hochohmigen Eingang 29 auf, der über den zweiten Widerstand 15a mit der Kathode der Leuchtiode 5a elektrisch verbunden ist. Bei dieser Beschaltung wird die (negative) Spannung bezogen auf H-Potential (Vcc) gemessen. Wie aus Fig. 2a unmittelbar ersichtlich ist, ergibt sich auf diese Weise eine sehr einfache Spannungsmeßschaltung.

Die Steuerschaltung 9a fragt im Tasteneingabemodus die am Ausgang des Analog/Digital-Wandlers 27 erhaltenen Signalwerte periodisch ab und prüft, ob sich der jeweils neu erhaltene Signalwert vom jeweils vorausgehenden Signalwert um mehr als eine vorgegebene Differenz unterscheidet. Ist dies der Fall, so wird dies von der Steuerschaltung 9a als Bedienung der logarithmischen optischen Taste 21, 23 ausgelegt, woraufhin die Steuerschaltung 9a den Anzeigemodus der Digitalanzeigeeinrichtung 19 umschaltet.

Die Erfassung und Auswertung der Differenz zweier unmittelbar aufeinander folgender Spannungswerte am Ausgang des Analog/Digital-Wandlers 27 dient dazu, rasche Änderungen in der Helligkeit des durch das Fenster 21 zur Leuchtdiode einfallenden Lichtes, wie sie typischerweise beim Aufsetzen eines Fingers auf die Bedienungsfläche 23 auftreten, sicher von langsameren Intensitätsschwankungen des Umgebungslichtes zu unterscheiden.

In Fig. 3a ist das Schaltbild eines weiteren Ausführungsbeispiels der Erfindung teils in Blockdarstellung gezeigt.

Elemente in Fig. 3a, die bereits unter Bezugnahme auf die Figuren 1a und 2a beschriebenen Elementen entsprechen, sind mit entsprechend gleichen Bezugsziffern und dem nachgestellten Buchstaben b gekennzeichnet, so daß zur Vermeidung von Wiederholungen insoweit auf die Beschreibung der Ausführungsbeispiele 1 und 2 verwiesen wird.

Bei dem Ausführungsbeispiel nach Fig. 3a wird die Leuchtdiode 5b in einem Tasteneingabebetriebsmodus ähnlich wie bei dem zweiten Ausführungsbeispiel als Tastenbetätigungssensor einer logarithmischen optischen Taste verwendet.

Abweichend zu dem zweiten Ausführungsbeispiel nach Fig. 2a ist jedoch kein Analog/Digital-Wandler zur Erfassung der Leerlaufspannung der Diode 5b erforderlich. Die Messung der Leerlaufspannung der Diode 5b erfolgt bei dem Ausführungsbeispiel nach Fig. 3a erfindungsgemäß nach einem einfachen Spannungs-Zeit-Wandlungsverfahren. Dabei wird im Tasteneingabemodus in einem ersten Schritt ein Kondensator 31 von der im Leerlauf-Spannungsgenerator-Modus betriebenen Leuchtdiode 5b in einigen ms auf die Diodenleerlaufspannung aufgeladen. In einem zweiten Schritt wird der Kondensator entladen und dabei die Zeit gemessen, bis die Spannung am Kondensator eine vorbestimmte Schaltschwelle unterschreitet.

Im Ausführungsbeispiel nach Fig. 3a ist der betreffende Kondensator 31 zwischen der Kathode der Leuchtdiode 5b und dem Anschluß D eines Tri-state-Ausgangsports 33 der Steuerschaltung 9b geschaltet.

Wie bei dem ersten und dem zweiten Ausführungsbeispiel steuert die vorzugsweise als Mikroprozessorschaltung ausgebildete Steuerschaltung 9b die verschiedenen Betriebszustände der Datensendeund -empfangsschaltung in einem Multiplexbetrieb.

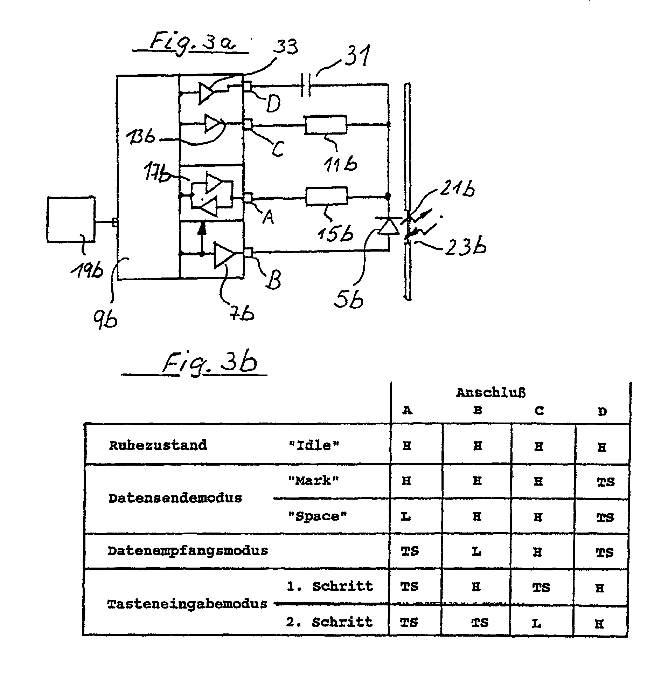

Gemäß der Zustandstabelle Fig. 3b ist der Anschluß D des Ports 33 sowohl im Datensendemodus als auch im Datenempfangsmodus im extrem hochohmigen Tri-state-Zustand TS. In bezug auf die äußere Beschaltung der Steuerschaltung 9b bedeutet dies, daß der Ausgangsport 33 elektrisch abgeschaltet ist. Die übrigen Anschlüsse A, B und C werden im Datensendemodus und im Datenempfangsmodus von der Steuerschaltung 9b in der gleichen Weise angesteuert, wie dies unter Bezugnahme auf die Figuren 1 und 2 in der Beschreibung der ersten beiden Ausführungsbeispiele erläutert wurde. Im Datensendemodus und im Datenempfangsmodus funktioniert die Schaltung nach Fig. 3a daher wie die Schaltung nach Fig. 2a, wobei der Kondensator 31 in Fig. 3a den Datensende- und -empfangsbetrieb nicht beeinträchtigt, da der Anschluß D elektrisch abgeschaltet ist.

Wie bereits angedeutet, ist der Tasteneingabemodus in zwei Schritte unterteilt. Dies sind die Schritte "Kondensator laden" und "Kondensator entladen sowie Entladezeit messen".

Im ersten Schritt sind die Anschlüsse A und C im hochohmigen Tri-state-Zustand TS, wohingegen die Anschlüsse B und D H-Pegel aufweisen, so daß die Diode 5b in den Leerlauf-Spannungsgenerator-Modus geschaltet ist. Die Diode 5b lädt nun den Kondensator 31 auf ihre von der Intensität des einfallenden Lichtes abhängige Leerlaufspannung auf, die im Beispiel der Fig. 3a auf H-Potential (Vcc) bezogen ist (Anschlüsse B und D an H-Potential).

In Fig. 3c ist der am Anschluß A des bidirektionalen Datenübertragungsports zu registrierende zeitliche Spannungsverlauf in einem Spannungs-Zeit-Diagramm für den Kondensatorladeschritt und den noch zu erläuternden Entladeschritt qualitativ dargestellt.

Die Kurve X_{L} in Fig. 3c zeigt den Spannungsverlauf am Anschluß A für den Fall, daß wenig Licht zu der als Photoelement wirksamen Diode 5b gelangt, wie dies der Fall ist, wenn das Fenster 21b der Bedienungsfläche 23b von einem Finger abgeschattet wird. Die Kurve Y_{L} gibt den Spannungsverlauf am Anschluß A für den Fall an, daß eine größere Lichtmenge zur Diode 5b gelangt, wie dies normalerweise der Fall ist, wenn das Fenster 21b nicht von außen abgeschattet ist.

Die sich nach Ablauf der vorbestimmten Ladezeit t_{L} am Anschluß A einstellende Spannung U entspricht dem Wert (Vcc - U_{D}), wobei Vcc die H-Pegel-Spannung (Betriebsspannung) und U_{D} die vom Lichteinfall in die Diode abhängige Diodenleerlaufspannung bezeichnet. Im Falle geringeren Lichteinfalls (Kurve X_{L}) ist die Leerlaufspannung U_{D} kleiner als im Falle stärkeren Lichteinfalls (Kurve Y_{L}), so daß bezogen auf Masse bzw. L-Potential die Spannung am Anschluß A nach Ablauf der Ladezeit t_{L} im Falle schwächeren Lichteinfalls größer ist als im Falle stärkeren Lichteinfalls.

Die Steuerschaltung 9b beendet den Kondensatorladeschritt bei Ablauf der vorbestimmten Zeit t_{L}, indem sie den Ausgangsport 7b (Anschluß B) in den hochohmigen Tri-state-Zustand TS umschaltet und den Anschluß C in den L-Pegel-Zustand versetzt. Hiermit ist dann der Kondensatorentladeschritt eingeleitet, wobei die Entladung des Kondensators 31 über den hochohmigen ersten Widerstand 11b und den Anschluß C nach Masse erfolgt. Die Steuerschaltung 9b mißt die Zeit t_{E}, die vergeht, bis die Spannung am Anschluß A auf die Schaltschwellspannung des im hochohmigen TS-Empfangszustand befindlichen Ports 17b abgesunken ist. Der Schaltschwellpegel des Ports 17b ist in Fig. 3c mit U_{H-L} gekennzeichnet. Unterschreitet die Spannung am Anschluß A diesen Pegel, so interpretiert die Steuerschaltung 9b dies als Übergang von H nach L.

Der Verlauf der Spannung am Anschluß A während des Kondensatorentladeschrittes ist in Fig. 3c durch die Kurve X_{E} für den Fall schwachen Lichteinfalls (optische Taste betätigt) - und durch die Kurve Y_{E} für den Fall stärkeren Lichteinfalls (optische Taste nicht betätigt) dargestellt.

Die Entladekurve X_{E} bzw. Y_{E} folgt in sehr guter Näherung der Beziehung U(t) = (Vcc - U_{D}) x exp(-t/τ).

Darin bezeichnet:
- U(t): die Spannung am Anschluß A
- Vcc: die H-Pegel-Spannung
- U_{D}: die Diodenleerlaufspannung
- τ: die Zeitkonstante.

Mit einem Kondensator 31 mit einer Kapazität von 1nF und einem 1,5 MΩ-Entladewiderstand 11b ergibt sich für die Zeitkonstante τ der Wert 1,5 ms.

Wie in Fig. 3c deutlich zu erkennen ist, unterschreitet die Kurve Y_{E} die Schaltschwellspannung U_{H-L} früher als die Kurve X_{E}, so daß die Mikroprozessorschaltung 9b anhand der Zeitmessung indirekt Informationen über den Belichtungszustand der Diode 5b erhält. Da es bei der logarithmischen optischen Taste nur auf relativ schnelle Änderungen (< 1 s) und nicht auf die Absolutwerte der Photospannung (Leerlaufspannung) der Diode 5b ankommt, ist diese sehr einfache Spannungs-Zeit-Wandlung für die Zwecke der Unterscheidung der Zustände "Taste betätigt" und "Taste nicht betätigt" vollkommen ausreichend.

Stellt die Mikroprozessorschaltung 9b nun bei zwei aufeinander folgenden Meßzyklen fest, daß die Kondensatorentladezeit t_{E} bis zum Unterschreiten von U_{H-L} beim zuletzt durchgeführten Meßzyklus länger war als beim vorausgehenden Meßzyklus, und zwar um eine Mindestdifferenz zum vorausgehenden Meßzyklus, so interpretiert sie dies als Betätigung der Taste 21b, 23b und schaltet den Anzeigemodus der Digitalanzeigeeinrichtung 19b um.

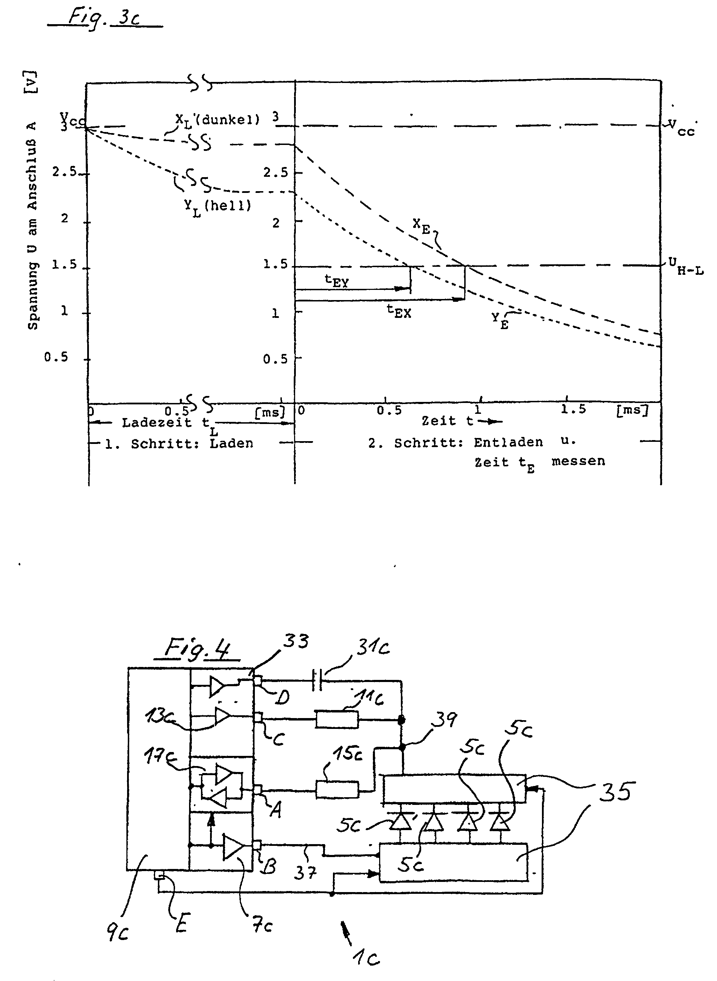

Das vorstehend beschriebene Prinzip der Realisierung und der Überwachung einer logarithmischen optischen Taste kann insbesondere auf ein optisches Tastenfeld mit mehreren Tasten ausgedehnt werden, wie dies schematisch in Fig. 4 angedeutet ist.

Das Ausführungsbeispiel nach Fig. 4 unterscheidet sich von dem nach Fig. 3a dadurch, daß anstelle einer Leuchtdiode 5b mehrere Leuchtdioden 5c vorgesehen sind, deren jede einer gesonderten optischen Taste eines (nicht gezeigten) Tastenbedienungsfeldes zugeordnet ist. Mit 35 ist in Fig. 4 eine Multiplexereinrichtung bezeichnet, die von der Mikroprozessorschaltung 9c über ein am Ausgang E abgegebenes Steuersignal derart angesteuert wird, daß sie selektiv jeweils eine der Leuchtdioden 5c anodenseitig mit der an dem Ausgangsanschluß B der Mikroprozessorschaltung 9c angeschlossenen Verbindungsleitung 37 und kathodenseitig mit dem Verbindungspunkt 39 des Kondensators 31c und der Widerstände 11c, 15c verbindet. Die Schaltung nach Fig. 4 arbeitet in bezug auf die jeweils in den Meßbetrieb einbezogene Diode 5c wie in dem Ausführungsbeispiel nach Fig. 3a. Die "Abfrage" der einzelnen Dioden 5c erfolgt in regelmäßigen Zeitabständen zyklisch.

Bei dem Ausführungsbeispiel nach Fig. 4 kann jede der Leuchtdioden 5c sowohl als logarithmische optische Taste als auch als optisches Sende- und Empfangselement in der beschriebenen Weise verwendet werden.

In Fig. 5 ist ein Anwendungsbeispiel für eine Datensende- und -empfangsschaltung nach der Erfindung illustriert. Gezeigt ist ein an einem Heizkörper 50 ortsfest montiertes elektronisches Verbrauchsmeßgerät (Heizkostenverteiler) 52 mit einer Infrarot-Optokommunikationsschnittstelle in Form einer Datensendeund -empfangsschaltung nach der Erfindung, wobei über die Optokommunikationsschnittstelle Heizkörper-Verbrauchsmeßdaten aus dem Verbrauchsmeßgerät 52 ausgelesen werden können. Hierzu ist ein transportables Auslesegerät 54 mit einem Optokopf 56 vorgesehen, der beispielsweise einen Phototransistor als optisches Empfangselement und eine Leuchtdiode als optisches Sendeelement zur Kommunikation mit dem Gerät 52 aufweist. Zur Datenübertragung zwischen der Optokommunikationsschnittstelle des Gerätes 52 und dem Optokopf 56 wird letzterer an das Fenster 21d des Gerätes 52 herangeführt, wobei hinter dem Fenster 21d die Leuchtdiode der Datensende- und -empfangsschaltung nach der Erfindung angeordnet ist. Es ist auch möglich, Daten vom Auslesegerät 54 über den Optokopf 56 zum Verbrauchsmeßgerät 52 hin zu übertragen, beispielsweise Auslesezeitpunkte und/oder Parameterwerte, die die Heizkörperklasse und dgl. spezifizieren und in dem Gerät 52 gespeichert werden. Die Steuerschaltung der Datensende- und -empfangsschaltung der Erfindung in dem Gerät 52 kann ein Mikroprozessor sein, der auch Aufgaben bezüglich der Verbrauchsmessung - und Meßwertauswertung übernimmt.

Die Digitalanzeigeeinrichtung 19d des Geräts 52 kann zwischen mehreren Anzeigebetriebsarten manuell umgeschaltet werden. Hierzu dient die Leuchtdiode hinter dem Fenster 21d des Gerätes 52 dann als Tastenbetätigungssensor in der bereits beschriebenen Weise. Tastenbetätigung in diesem Sinne liegt vor, wenn das Fenster 21d beispielsweise mit einem Finger abgeschattet wird.

In einer dem Ausführungsbeispiel nach Fig. 5 ähnlichen Weise kann eine Datensende- und -empfangsschaltung nach der Erfindung beispielsweise auch bei anderen elektronischen Verbrauchszählern, beispielsweise Wasserzählern, Wärmemengenzählern, Gaszählern, Stromzählern usw., Verwendung finden. Diese Aufzählung ist keinesfalls abschließend. Die Erfindung kann überall dort eingesetzt werden, wo bidirektionale Datenübertragung im Halbduplexbetrieb über Optokopplung stattfinden soll.

## Patentansprüche

1. Datensende- und -empfangsschaltung zum Senden und Empfangen von optischen Datensignalen, bei der wenigstens eine Leuchtdiode (5; 5a; 5b; 5c) als optoelektronisches Sendeelement zur Umwandlung eines elektrischen Datensignals in ein optisches Datensignal und zum Senden des optischen Datensignals an einer das elektrische Datensignal in einem Datensendemodus der Datensende- und -empfangsschaltung bereitstellenden Steuerschaltung (9; 9a; 9b; 9c) angeschlossen ist,
**dadurch gekennzeichnet,**
**daß** die Leuchtdiode (5; 5a; 5b; 5c) in einem Datenempfangsmodus der Datensende- und -empfangsschaltung von der Steuerschaltung (9; 9a; 9b; 9c) derart angesteuert ist, daß sie als optoelektronisches Datenempfangselement zur Umwandlung eines von ihr empfangenen optischen Datensignals in ein von der Steuerschaltung (9; 9a; 9b; 9c) registriertes elektrisches Datensignal wirksam ist, wobei die Steuerschaltung (9; 9a; 9b; 9c) die Leuchtdiode (5; 5a; 5b; 5c) in Sperrichtung vorspannt und ein vom Sperrstrom der Leuchtdiode (5; 5a; 5b; 5c) und somit von der Intensität des in die Leuchtdiode einfallenden Lichtes abhängiges elektrisches Signal in einer binäre Zustände des von der Leuchtdiode empfangenen optischen Datensignals unterscheidenden Weise detektiert.

2. Datensende- und -empfangsschaltung nach einem der vorhergehenden Ansprüche, **dadurch gekennzeichnet, daß** die Leuchtdiode (5; 5a; 5b; 5c) kathodenseitig über einen ersten Widerstand (11; 11a; 11b; 11c) mit einem H-Potential führenden Anschluß (C) der Steuerschaltung (9; 9a; 9b; 9c) - und anodenseitig mit einem AnSchluß (B) der Steuerschaltung (9; 9a; 9b; 9c) verbunden ist, der im Datensendemodus H-Potential und im Datenempfangsmodus L-Potential führt, und daß die Steuerschaltung (9; 9a; 9b; 9c) einen mit der Kathode der Leuchtdiode (5; 5a; 5b; 5c) verbundenen Anschluß (A) zur Abgabe eines elektrischen Datensignals im Datensendemodus aufweist.

3. Datensende- und -empfangsschaltung nach einem der vorhergehenden Ansprüche, **dadurch gekennzeichnet, daß** die Steuerschaltung (9; 9a; 9b; 9c) einen mit der Kathode der Leuchtdiode verbundenen Anschluß (A) zur Erfassung der vom Sperrstrom der Leuchtdiode (5; 5a; 5b; 5c) abhängigen Spannung im Datenempfangsmodus aufweist.

4. Datensende- und -empfangsschaltung nach einem der vorhergehenden Ansprüche, **dadurch gekennzeichnet, daß** die Steuerschaltung (9; 9a; 9b; 9c) einen Anschluß (A) für bidirektionale Datenübertragung hat, über den sie im Datensendemodus das elektrische Datensignal bereitstellt und über den sie im Datenempfangsmodus die vom Sperrstrom der Leuchtdiode (5; 5a; 5b; 5c) abhängige Spannung detektiert.

5. Datensende- und -empfangsschaltung nach einem der vorhergehenden Ansprüche, **dadurch gekennzeichnet, daß** die Steuerschaltung (9; 9a; 9b; 9c) einen Mikroprozessor zur Steuerung des Datensendebetriebs und des Datenempfangsbetriebs der Datensende- und -empfangsschaltung aufweist.

6. Datensende- und -empfangsschaltung nach einem der vorhergehenden Ansprüche, **dadurch gekennzeichnet, daß** die Steuerschaltung (9; 9a; 9b; 9c) eine serielle Schnittstelle zur bidirektionalen asynchronen Datenübertragung über die Leuchtdiode (5; 5a; 5b; 5c) im Halbduplex-Betrieb aufweist.

7. Datensende- und -empfangsschaltung nach einem der vorhergehenden Ansprüche, **dadurch gekennzeichnet, daß** die Leuchtdiode (5a; 5b; 5c) in einem Gehäuse (25) mit einer zur Leuchtdiode hin lichtdurchlässigen Gehäuseöffnung (21; 21b) angeordnet ist, die einer Tastenfläche (23; 23b) für manuelle Dateneingabe zugeordnet ist, daß die Datensende- und -empfangsschaltung ferner in einem Tasteneingabemodus unter Kontrolle der Steuerschaltung (9a; 9b; 9c) betreibbar ist, in dem die Leuchtdiode (5a; 5b; 5c) als Photoelement wirksam ist und die Steuerschaltung (9a; 9b; 9c) die von der Intensität des von der Leuchtdiode empfangenen Lichtes abhängige Leerlaufspannung der Leuchtdiode erfaßt, um eine den Lichtdurchlaß zur Leuchtdiode verändernde plötzliche Abschattung der Gehäuseöffnung (21; 21b) als manuellen Dateneingabevorgang zu registrieren.

8. Datensende- und -empfangsschaltung nach Anspruch 7, **dadurch gekennzeichnet, daß** die Leuchtdiode (5a) im Tasteneingabemodus anodenseitig mit H-Potential - und kathodenseitig mit einem hochohmigen Eingang (29) eines Analog/Digital-Wandlers (27) der Steuerschaltung (9a) verbunden ist und daß die Steuerschaltung (9a) einen Mikroprozessor zur Auswertung der von dem Analog/Digital-Wandler (27) bereitgestellten digitalen Informationen aufweist.

9. Datensende- und -empfangsschaltung nach Anspruch 7, **dadurch gekennzeichnet, daß** die Leuchtdiode (5b; 5c) mit einem Kondensator (31; 31c) verbunden ist, der in einem Ladebetriebszustand der Steuerschaltung (9b; 9c) im Tasteneingabemodus einen der Leerlaufspannung der Leuchtdiode (5b; 5c) entsprechenden Ladezustand annimmt und der in einem nachfolgenden Entladebetriebszustand der Steuerschaltung (9b; 9c) im Tasteneingabemodus über einen Entladewiderstand (11b; 11c) entladbar ist, wobei die Steuerschaltung (9b; 9c) einen mit einem Verbindungspunkt zwischen der Leuchtdiode (5b; 5c) und dem Kondensator (31; 31c) verbundenen Anschluß (A) eines hochohmigen Eingangsports zur Überwachung der Kondensatorentladung aufweist und dazu eingerichtet ist, als Maß für die Leerlaufspannung der Leuchtdiode (5b; 5c) die Zeit zu messen, die vergeht, bis die an dem Anschluß (A) des Eingangsports anliegende Spannung während des Kondensatorentladevorgangs eine vorbestimmte Schaltschwellspannung des Eingangsports erreicht.

10. Datensende- und -empfangsschaltung nach Anspruch 9, **dadurch gekennzeichnet,**
**daß** die Leuchtdiode (5b; 5c) anodenseitig mit einem Anschluß (B) eines ersten Ausgangsports der Steuerschaltung (9b; 9c) - und kathodenseitig über den Kondensator (31; 31c) mit einem H-Potential führenden Anschluß (D) eines dritten Ausgangs ports der Steuerschaltung (9b; 9c) verbunden ist und daß die Leuchtdiode (5b; 5c) kathodenseitig ferner über den Entladewiderstand (11b; 11c) mit einem Anschluß (C) eines zweiten Ausgangsports der Steuerschaltung (9b; 9c) - und über einen weiteren Widerstand (15b; 15c) mit dem Anschluß (A) des hochohmigen Eingangsports verbunden ist, ersten Ausgangsports im
wobei der Anschluß (B) des ersten Ausgangsports im Ladebetriebszustand H-Potential führt und im Entladebetriebszustand in einen hochohmigen Tri-state-Zustand geschaltet ist, wobei der Anschluß (C) des zweiten Ausgangsports im Ladebetriebszustand in einen hochohmigen Tri-state-Zustand geschaltet ist und im Entladebetriebszustand definiertes L-Potential führt, und wobei die Steuerschaltung (9b; 9c) im Entladebetriebszustand als Maß für die Leerlaufspannung der Leuchtdiode (5b; 5c) die Zeit mißt, die vergeht, bis die Spannung an dem Anschluß (A) des hochohmigen Eingangsports auf die Schaltschwellspannung des Eingangsports abgesunken ist, deren Unterschreiten die Steuerschaltung (9b; 9c) als Übergang von H-Pegel nach L-Pegel interpretiert.

11. Datensende- und -empfangsschaltung nach einem der vorhergehenden Ansprüche, **dadurch gekennzeichnet, daß** sie als optische Kommunikationsschnittstelle eines Meßgerätes (52), insbesondere eines Verbrauchszählers, ausgebildet ist, welches zum optischen Datenaustausch mit einem Auslesegerät (54) eingerichtet ist.

## Claims

1. Data transmitting and receiving circuit for transmitting and receiving optical data signals, in which at least one light-emitting diode (5; 5a; 5b; 5c) is connected, as an optoelectronic transmitting element for converting an electric data signal into an optical data signal and for transmitting the optical data signal, to a control circuit (9; 9a; 9b; 9c) providing the electric data signal in a data transmitting mode of the data transmitting and receiving circuit, **characterised in that** the light-emitting diode (5; 5a; 5b; 5c) is driven in a data receiving mode of the data transmitting and receiving circuit (9; 9a; 9b; 9c) in such a way that it acts as an optoelectronic data receiving element for converting an optical data signal received by it into an electric data signal registered by the control circuit (9; 9a; 9b; 9c), wherein the control circuit (9; 9a; 9b; 9c) biases the light-emitting diode (5; 5a; 5b; 5c) in the cut-off direction and detects an electric signal dependent on the cut-off current of the light-emitting diode (5; 5a; 5b; 5c) and thus on the intensity of the light incident into the light-emitting diode in a manner distinguishing binary states of the optical data signal received by the light-emitting diode.

2. Data transmitting and receiving circuit according to any one of the preceding claims (*sic*), **characterised in that** the light-emitting diode (5; 5a; 5b; 5c) is connected on the cathode side via a first resistor (11; 11a; 11b; 11c) to a connection (C) of the control circuit (9; 9a; 9b; 9c) conducting H-potential and on the anode side to a connection (B) of the control circuit (9; 9a; 9b; 9c), which conducts H potential in data transmitting mode and L potential in data receiving mode and the control circuit (9; 9a; 9b; 9c) has a connection (A) connected to the cathode of the light-emitting diode (5; 5a; 5b; 5c) for emitting an electric data signal in data transmitting mode.

3. Data transmitting and receiving circuit according to any one of the preceding claims, **characterised in that** the control circuit (9; 9a; 9b; 9c) has a connection (A) connected to the cathode of the light-emitting diode for detecting the voltage dependent on the cut-off current of the light-emitting diode (5; 5a; 5b; 5c) in data receiving mode.

4. Data transmitting and receiving circuit according to any one of the preceding claims, **characterised in that** the control circuit (9; 9a; 9b; 9c) has a connection (A) for bi-directional data transfer, via which in data transmitting mode it provides the electric data signal and via which in data receiving mode it detects the voltage dependent on the cut-off current of the light-emitting diode (5; 5a; 5b; 5c).

5. Data transmitting and receiving circuit according to any one of the preceding claims, **characterised in that** the control circuit (9; 9a; 9b; 9c) has a microprocessor for controlling the data transmitting operation and the data receiving operation of the data transmitting and receiving circuit.

6. Data transmitting and receiving circuit according to any one of the preceding claims, **characterised in that** the control circuit (9; 9a; 9b; 9c) has a serial interface for bi-directional asynchronous data transfer via the light-emitting diode (5; 5a; 5b; 5c) in half-duplex operation.

7. Data transmitting and receiving circuit according to any one of the preceding claims, **characterised in that** the light-emitting diode (5a; 5b; 5c) is arranged in a housing (25) with a housing orifice (21; 21b) transparent towards the light-emitting diode and assigned to a keyboard face (23; 23b) for manual data input, the data transmitting and receiving circuit can further be operated in a keyboard input mode under the control of the control circuit (9a; 9b; 9c), in which mode the light-emitting diode (5a; 5b; 5c) acts as photo-element and the control circuit (9a; 9b; 9c) detects the open-circuit voltage of the light-emitting diode dependent on the intensity of the light received by the light-emitting diode, in order to register a sudden shadowing of the housing orifice (21; 21b) changing the transparency to the light-emitting diode as a manual data input process.

8. Data transmitting and receiving circuit according to claim 7, **characterised in that** the light-emitting diode (5a) is connected in keyboard input mode on the anode side with H potential and on the cathode side with a high ohm input (29) of an analog to digital converter (27) of the control circuit (9a) and the control circuit (9a) has a microprocessor for evaluating the digital information provided by the analog to digital converter.

9. Data transmitting and receiving circuit according to claim 7, **characterised in that** the light-emitting diode (5b; 5c) is connected to a capacitor (31; 31c) which takes on a charging state corresponding to the open-circuit voltage of the light-emitting diode (5b; 5c) in a charging operating state of the control circuit (9b; 9c) in the keyboard input mode and which in a subsequent discharging operating state of the control circuit (9b; 9c) in keyboard input mode can be discharged via a discharging resistor (11b; 11c), wherein the control circuit (9b; 9c) has a connection (A) of a high ohm input port connected to a connecting point between the light-emitting diode (5b; 5c) and the capacitor (31; 31c) for monitoring the discharging of the capacitor and is arranged so as to measure the time which passes before the voltage applied to connection (A) of the input port during the capacitor discharging process reaches a predetermined circuit threshold voltage of the input port, as a measurement for the open-circuit voltage of the light-emitting diode (5b; 5c).

10. Data transmitting and receiving circuit according to claim 9, **characterised in that** the light-emitting diode (5b; 5c) is connected on the anode side to a connection (B) of a first output port of the control circuit (9b; 9c) and on the cathode side via the capacitor (31; 31c) to a connection (D) of a third output port of the control circuit (9b; 9c) conducting H potential and the light-emitting diode (5b; 5c) is further connected on the cathode side via the discharging resistor (11b; 11c) to a connection (C) of a second output port of the control circuit (9b; 9c) and via a further resistor (15b; 15c) to connection (A) of the high ohm input port, wherein connection (B) of the first output port conducts H potential in the charging operating state and in the discharging operating state is switched into a high ohm tri-state, wherein connection (C) of the second output port is switched in the charging operating state into a high ohm tri-state and in the discharging operating state conducts defined L potential and wherein the control circuit (9b; 9c) in the discharging operating state, as measurement for the open-circuit voltage of the light-emitting diode (5b; 5c), measures the time which passes before the voltage at connection (A) of the high ohm input port has dropped to the circuit threshold voltage of the input port, going below which is interpreted by the control circuit (9b; 9c) as the transition from H level to L level.

11. Data transmitting and receiving circuit according to any one of the preceding claims, **characterised in that** it is constructed as an optical communication interface of a measuring device (52), in particular of a supply metre arranged for optical data exchange with a reading out device (54).

## Revendications

1. Circuit d'émission et de réception de données pour l'émission et la réception de signaux optiques de données, dans lequel une diode luminescente (5 ; 5a ; 5b ; 5c) est raccordée en tant qu'élément émetteur optoélectronique, pour la conversion d'un signal électrique de données en un signal optique de données et pour l'émission du signal optique de données, à un circuit de commande (9 ; 9a ; 9b ; 9c) qui délivre le signal électrique de données dans un mode d'émission de données du circuit d'émission et de réception de données,
**caractérisé en ce que**
la diode luminescente (5 ; 5a ; 5b ; 5c) est commandée dans un mode de réception de données du circuit d'émission et de réception de données par le circuit de commande (9 ; 9a ; 9b ; 9c) de manière à ce qu'elle opère comme élément optoélectronique de réception de données pour la conversion d'un signal optique de données reçu en un signal électrique de données enregistré par le circuit de commande (9; 9a ; 9b ; 9c), le circuit de commande (9 ; 9a ; 9b ; 9c) forçant la diode luminescente (5 ; 5a ; 5b ; 5c) dans le sens du blocage et détectant un signal électrique qui dépend du courant à l'état bloqué de la diode luminescente (5 ; 5a ; 5b ; 5c) et donc de l'intensité de la lumière entrant dans la diode luminescente, d'une manière qui fait la distinction entre des états binaires du signal optique de données reçu par la diode luminescente.

2. Circuit d'émission et de réception de données selon la revendication 1, **caractérisé en ce que** la diode luminescente (5 ; 5a ; 5b ; 5c) est reliée côté cathode, à travers une première résistance (11 ; 11a ; 11b ; 11c), à une home (C) conduisant le potentiel H du circuit de commande (9 ; 9a ; 9b ; 9c) - et côté anode, à une borne (B) du circuit de commande (9 ; 9a ; 9b ; 9c) qui conduit le potentiel H en mode émission de données et le potentiel L en mode réception de données, et **en ce que** le circuit de commande (9 ; 9a ; 9b ; 9c) comporte une borne (A) reliée à la cathode de la diode luminescente (5 ; 5a ; 5b ; 5c) pour délivrer un signal électrique de données en mode émission de données.

3. Circuit d'émission et de réception de données selon l'une des revendications précédentes, **caractérisé en ce que** le circuit de commande (9 ; 9a ; 9b ; 9c) comporte une borne (A) reliée à la cathode de la diode luminescente pour détecter en mode réception de données la tension qui dépend du courant à l'état bloqué de la diode luminescente (5 ; 5a ; 5b ; 5c).

4. Circuit d'émission et de réception de données selon l'une des revendications précédentes, **caractérisé en ce que** le circuit de commande (9 ; 9a ; 9b ; 9c) possède une borne (A) pour la transmission bidirectionnelle des données, à travers laquelle il délivre, en mode émission de données, le signal électrique de données, et à travers laquelle, en mode réception de données, il détecte la tension qui dépend du courant à l'état bloqué de la diode luminescente (5 ; 5a ; 5b ; 5c).

5. Circuit d'émission et de réception de données selon l'une des revendications précédentes, **caractérisé en ce que** le circuit de commande (9 ; 9a ; 9b ; 9c) comporte un microprocesseur pour la commande du mode émission de données et du mode réception de données du circuit d'émission et de réception des données.

6. Circuit d'émission et de réception de données selon l'une des revendications précédentes, **caractérisé en ce que** le circuit de commande (9 ; 9a ; 9b ; 9c) comporte une interface série pour la transmission bidirectionnelle asynchrone des données à travers la diode luminescente (5 ; 5a ; 5b ; 5c) en mode semi-duplex.

7. Circuit d'émission et de réception de données selon l'une des revendications précédentes, **caractérisé en ce que** la diode luminescente (5a ; 5b ; 5c) est disposée dans un boîtier (25) avec une ouverture (21 ; 21b) du boîtier qui laisse passer la lumière vers la diode luminescente et à laquelle est associée une surface à touches (23 ; 23b) pour la saisie manuelle des données, **en ce que** le circuit d'émission et de réception des données peut fonctionner en outre dans un mode de saisie par touches sous contrôle du circuit de commande (9a ; 9b ; 9c), dans lequel la diode luminescente (5a ; 5b ; 5c) sert de photo-élément et le circuit (9a ; 9b ; 9c) détecte la tension à vide de la diode luminescente qui dépend de l'intensité de la lumière reçue par la diode luminescente, afin d'enregistrer une occultation brusque de l'ouverture (21 ; 21b) du boîtier, qui modifie le passage de la lumière vers la diode luminescente, en tant qu'opération manuelle de saisie des données.

8. Circuit d'émission et de réception de données selon la revendication 7, **caractérisé en ce que** dans le mode de saisie par touches, la diode luminescente (5a) est reliée côté anode au potentiel H - et côté cathode à une entrée (29) de grande valeur ohmique d'un convertisseur analogique/numérique (27) du circuit de commande (9a), et **en ce que** le circuit de commande (9a) comporte un microprocesseur pour l'exploitation des informations numériques fournies par le convertisseur analogique/numérique (27).

9. Circuit d'émission et de réception de données selon la revendication 7, **caractérisé en ce que** la diode luminescente (5b ; 5c) est reliée à un condensateur (31 ; 31c) qui, dans un état de fonctionnement sous charge du circuit de commande (9b, 9c) et en mode de saisie par touches, prend un état de charge correspondant à la tension à vide de la diode luminescente (5b ; 5c), et qui dans un état suivant de fonctionnement en décharge du circuit de commande (9b ; 9c) et en mode de saisie par touches, peut être déchargé à travers une résistance de décharge (11b ; 11c), le circuit de commande (9b ; 9c) comportant une borne (A), reliée à un point de liaison entre la diode luminescente (5b ; 5c) et le condensateur (31 ; 31c), d'un port d'entrée de grande valeur ohmique pour la surveillance de la décharge du condensateur, et est aménagé pour mesurer, en tant que critère de la tension à vide de la diode luminescente (5b ; 5c), le temps qui s'écoule jusqu'à ce que la tension qui s'applique à la borne (A) du port d'entrée atteigne, pendant l'opération de décharge du condensateur, une tension de seuil de commutation prédéterminée du port d'entrée.

10. Circuit d'émission et de réception de données selon la revendication 9,
**caractérisé en ce que**
la diode luminescente (5b ; 5c) est reliée côté anode à une borne (B) d'un premier port de sortie du circuit de commande (9b ; 9c) - et côté cathode, à travers le condensateur (31 ; 31c) à une borne (D), conduisant un potentiel H, d'un troisième port de sortie du circuit de commande (9b ; 9c) et **en ce que** la diode luminescente (5b ; 5c) est reliée en outre, côté cathode, à travers la résistance de décharge (11b ; 11c), à une borne (C) d'un deuxième port de sortie du circuit de commande (9b ; 9c) - et à travers une autre résistance (15b ; 15c) à la borne (A) du port d'entrée de grande valeur ohmique, et la home (B) du premier port de sortie dans l'état de fonctionnement sous charge mène au potentiel H, et dans l'état de fonctionnement en décharge est commandée dans un état parmi trois états de grande valeur ohmique, et la borne (C) du deuxième port de sortie dans l'état de fonctionnement sous charge est commandée dans un état parmi trois états de grande valeur ohmique, et dans l'état de fonctionnement en décharge conduit un potentiel L défini, et le circuit de commande (9b ; 9c) dans l'état de fonctionnement en décharge mesure, en tant que critère de la tension à vide de la diode luminescente (5b ; 5c), le temps qui s'écoule jusqu'à ce que la tension sur la borne (A) du port d'entrée de grande valeur ohmique diminue jusqu'à la valeur de seuil de commutation du port d'entrée dont le sous-dépassement est interprété par le circuit de commande (9b ; 9c) comme un passage du niveau H au niveau L.

11. Circuit d'émission et de réception de données selon l'une des revendications précédentes, **caractérisé en ce qu'**il est réalisé en tant qu'interface optique de communication d'un appareil de mesure (52), en particulier d'un compteur de consommation, qui est aménagé pour l'échange optique de données avec un appareil de lecture (54).
